(19) **Europäisches Patentamt**

**European Patent Office**

**Office européen des brevets**

(11) **EP 0 813 295 B1**

(12) **FASCICULE DE BREVET EUROPEEN**

(45) Date de publication et mention
de la délivrance du brevet:
**30.10.2002 Bulletin 2002/44**

(51) Int Cl.⁷: **H03G 3/00**, H03G 1/00

(21) Numéro de dépôt: **97201706.5**

(22) Date de dépôt: **05.06.1997**

(54) **Amplificateur à gain contrôlé numériquement et caméra mettant en oeuvre un tel amplificateur**

Verstärker mit digital gesteuerter Verstärkung und Kamera mit einem solchen Verstärker

Amplifier with digital gain control and camera using such an amplifier

(84) Etats contractants désignés:
**DE FR GB IT**

(30) Priorité: **14.06.1996 FR 9607446**

(43) Date de publication de la demande:
**17.12.1997 Bulletin 1997/51**

(73) Titulaire: **Koninklijke Philips Electronics N.V.**
**5621 BA Eindhoven (NL)**

(72) Inventeurs:
• **Darthenay, Frédéric**
**75008 Paris (FR)**

• **Morisson, Richard**
**75008 Paris (FR)**
• **Raoulx, Denis**
**75008 Paris (FR)**

(74) Mandataire: **Charpail, François et al**
**Société Civile S.P.I.D.**
**156, Boulevard Haussmann**
**75008 Paris (FR)**

(56) Documents cités:
**US-A- 4 335 356      US-A- 4 462 003**
**US-A- 4 543 561**

## Description

La présente invention concerne un amplificateur à gain contrôlé, présentant une entrée analogique destinée à recevoir une tension dite tension analogique d'entrée, une entrée numérique destinée à recevoir un mot de N bits, dit mot de commande, servant à contrôler le gain de l'amplificateur, et une sortie analogique destinée à délivrer une tension dite tension analogique de sortie.

La plupart des amplificateurs à gain contrôlé à l'aide d'un mot de commande numérique contiennent un convertisseur numérique/analogique qui opère la conversion du mot de commande en un signal analogique. Ce signal est ensuite utilisé, soit pour commander la conduction d'une source de courant qui réalise une polarisation d'un étage amplificateur au moyen duquel la tension analogique d'entrée est effectivement amplifiée, soit comme multiplicande du signal analogique d'entrée dans un circuit multiplicateur.

Un tel amplificateur est connu du brevet US 4,335,356.

Ces amplificateurs à gain contrôlé présentent donc deux inconvénients majeurs : le convertisseur numérique/analogique qu'ils contiennent conduit à un circuit de grande taille, et l'erreur produite lors de la conversion du mot de commande se trouve multipliée par le gain intrinsèque de l'amplificateur.

La présente invention a pour but de remédier à ces inconvénients en proposant un amplificateur dans lequel le mot de commande agit directement sur le résultat de l'amplification de la tension analogique d'entrée.

En effet, un amplificateur à gain contrôlé selon la présente invention est caractérisé en ce qu'il comprend :

. un étage dit de transconductance présentant une entrée de tension formant l'entrée analogique de l'amplificateur, et N sorties de courant, muni de moyens pour produire sur chacune de ses N sorties de courant un courant présentant une composante variable représentative de la tension analogique d'entrée,

. un étage dit de commutation présentant N entrées de commande, et comprenant N interrupteurs, commandés chacun par un signal reçu sur l'une des N entrées de commande, chaque interrupteur commandant l'activation ou la désactivation de l'une des sorties de courant de l'étage de transconductance, les N entrées de commande formant l'entrée numérique de l'amplificateur, destinée à recevoir le mot de commande,

. un étage dit de conversion courant/tension présentant N entrées de courant et une sortie de tension, les N entrées de courant étant reliées aux N sorties de courant de l'étage de transconductance, la sortie de tension formant la sortie analogique de l'amplificateur, et délivrant une tension représentative des courants reçus sur ses N entrées de courant.

Dans un tel amplificateur, l'amplification proprement dite a lieu directement dans l'étage de transconductance et indépendamment de la valeur du mot de commande. L'étage de commutation permet au mot de commande de sélectionner directement celles des sorties de l'étage de transconductance qui doivent être activées. La tension analogique de sortie est le résultat d'une combinaison linéaire des sorties de l'étage de transconductance, combinaison qui est réalisée par l'étage de conversion courant/tension. Le résultat de cette combinaison varie en fonction du nombre et de la nature des sorties de l'étage de transconductance qui sont actives, et donc de la valeur numérique du mot de commande.

Un mode de réalisation de l'invention présente un amplificateur à gain contrôlé tel que défini dans le paragraphe introductif, caractérisé en ce qu'il comprend :

. un étage dit de polarisation présentant N sorties et constitué de N sources de courant, chacune ayant une borne reliée à une borne négative d'alimentation, l'autre borne formant l'une des dites N sorties,

. un étage dit de transconductance présentant une entrée de tension formant l'entrée analogique de l'amplificateur, N entrées de courant reliées aux N sorties de l'étage de polarisation, et N sorties de courant, et constitué de N modules dits de transconductance, chacun d'eux présentant une entrée de tension reliée à l'entrée de tension de l'étage, une entrée de courant constituant une entrée de courant de l'étage, et une sortie de courant formant une des N sorties de courant de l'étage et délivrant un courant présentant une composante variable représentative de la tension analogique d'entrée,

. un étage dit de commutation présentant N entrées de commande, N entrées de courant et N sorties de courant, et comprenant N interrupteurs, commandés chacun par un signal reçu sur l'une des N entrées de commande, l'une des bornes de chaque interrupteur formant l'une des N entrées de courant de l'étage, l'autre borne formant l'une des N sorties de courant de l'étage, les N entrées de courant de l'étage étant reliées aux N sorties de courant de l'étage de transconductance, les N entrées de commande formant l'entrée numérique de l'amplificateur, destinée à recevoir le mot de commande,

. un étage dit de conversion courant/tension présentant N entrées de courant et une sortie de tension, les N entrées de courant étant reliées aux N sorties de courant de l'étage de commutation, la sortie de tension formant la sortie analogique de l'amplificateur, et délivrant une tension représentative des courants reçus sur ses N entrées de courant.

Un autre mode de réalisation de l'invention présente un amplificateur à gain contrôlé tel que décrit ci-dessus, caractérisé en ce que l'étage de conversion courant/tension comprend un réseau R/2R, dans lequel deux entrées de courant successives sont reliées l'une à l'autre par une résistance de valeur nominale égale à R, l'entrée de courant qui est reliée à la sortie de l'étage de transconductance commandée par le bit de poids le plus fort du mot de commande étant reliée par une résistance de valeur nominale égale à R à la sortie analogique de l'amplificateur, l'entrée de courant qui est reliée à la sortie de l'étage de transconductance commandée par le bit de poids le plus faible du mot de commande étant reliée à la borne négative d'alimentation par une résistance de valeur nominale égale à R, chacune des autres entrées de courant étant reliée à la borne négative d'alimentation par une résistance de valeur nominale égale à 2R.

La conversion courant/tension qui est réalisée par le réseau R/2R permet de pondérer la contribution du courant reçu sur chacune des entrées de courant en fonction du rang occupé par cette dernière. Une telle configuration est donc bien adaptée à des applications où la valeur en sortie dépend d'un mot de commande numérique dont les bits ont des poids différents.

Ceci est particulièrement utile dans une variante de l'invention qui présente un amplificateur à gain contrôlé tel que décrit plus haut, caractérisé en ce que les sources de courant de l'étage de polarisation sont toutes de construction identique et munies chacune d'une entrée de commande permettant de contrôler la valeur du courant qu'elle débite, en fonction de la valeur du mot de commande.

Dans un tel amplificateur de courant, seul le réseau R/2R assure la pondération nécessaire au contrôle du gain de l'amplificateur en fonction de la valeur du mot de commande.

Une variante de l'invention présente un amplificateur à gain contrôlé tel que décrit plus haut, caractérisé en ce que chaque module de transconductance est muni de moyens pour produire à sa sortie de courant un courant dont la composante variable est indépendante de la valeur du courant débité par la source de courant à laquelle ledit module est relié.

Cette variante de l'invention permet de régler le niveau continu de la tension analogique de sortie en modifiant la valeur du courant débité par les sources de courant de l'étage de polarisation, sans pour autant modifier la valeur du gain appliqué à la tension analogique d'entrée.

Un mode de réalisation avantageux de l'invention exploite cette possibilité en présentant un amplificateur à gain contrôlé tel que décrit ci-dessus, caractérisé en ce qu'il comprend un comparateur présentant une sortie et deux entrées, dont l'une reçoit une tension de référence, et l'autre reçoit la tension de sortie de l'amplificateur, la sortie du comparateur étant reliée à l'entrée de commande de chacune des sources de courant de l'étage de polarisation.

Un autre mode de réalisation avantageux de l'invention permet également de régler le niveau continu de la tension analogique de sortie, présentant un amplificateur à gain contrôlé tel que décrit ci-dessus, caractérisé en ce qu'il comprend une mémoire dite associative, adressée par au moins une partie du mot de commande et délivrant en sortie une valeur numérique précalculée correspondant à la configuration de la dite partie du mot de commande, amplificateur comprenant de plus un convertisseur numérique/analogique muni d'une entrée numérique reliée à la sortie de la mémoire associative et d'une sortie analogique reliée à l'entrée de commande de chacune des sources de courant de l'étage de polarisation.

L'invention concerne également une caméra contenant :

. un dispositif de détection de lumière et de conversion de la lumière en signaux électroniques analogiques,
. un amplificateur présentant une entrée de signal analogique destinée à recevoir les dits signaux électroniques analogiques, une entrée numérique destinée à recevoir un mot numérique, dit mot de commande, pour contrôler le gain de l'amplificateur, et une sortie de signal analogique,
. un convertisseur analogique/numérique présentant une entrée analogique reliée à la sortie de l'amplificateur, et une sortie numérique, et
. une unité de traitement numérique dont une entrée est reliée à la sortie du convertisseur analogique/numérique, unité destinée à émettre le mot de commande vers l'amplificateur,

caractérisée en ce que l'amplificateur qu'elle contient est tel que décrit plus haut.

L'invention sera mieux comprise à l'aide de la description suivante, faite à titre d'exemple et en regard des dessins annexés, dans lesquels :

- la figure 1 est un schéma fonctionnel décrivant partiellement un amplificateur à gain contrôlé selon l'invention,
- la figure 2 est un schéma qui représente un module de transconductance présent dans un amplificateur à gain contrôlé selon une variante de l'invention,
- la figure 3 est un schéma qui représente un dispositif de régulation de niveau continu présent dans un amplificateur à gain contrôlé selon un mode de réalisation avantageux de l'invention,
- la figure 4 est un schéma qui représente un dispositif de régulation de niveau continu présent dans un amplificateur à gain contrôlé selon un autre mode de réalisation avantageux de l'invention, et
- la figure 5 est un schéma fonctionnel décrivant partiellement une caméra mettant en ouvre un amplificateur à gain contrôlé selon l'invention.

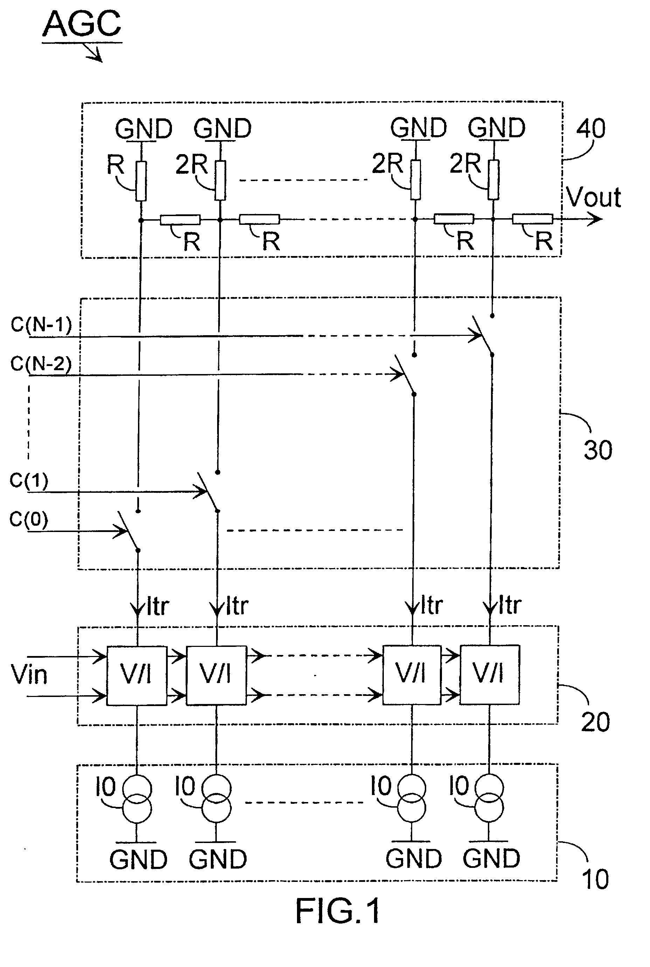

Selon la figure 1, un amplificateur à gain contrôlé AGC conforme à l'invention comprend :

.   un étage 10 dit de polarisation présentant N sorties et constitué de N sources de courant I0, chacune ayant une borne reliée à une borne négative d'alimentation GND, l'autre borne formant l'une des dites N sorties,

.   un étage 20 dit de transconductance présentant une entrée de tension formant l'entrée analogique de l'amplificateur, N entrées de courant reliées aux N sorties de l'étage de polarisation, et N sorties de courant, et constitué de N modules V/I dits de transconductance, chacun d'eux présentant une entrée de tension reliée à l'entrée de tension de l'étage, une entrée de courant constituant une entrée de courant de l'étage, et une sortie de courant formant une des N sorties de courant de l'étage et délivrant un courant Itr présentant une composante variable représentative de la tension analogique d'entrée Vin,

.   un étage 30 dit de commutation présentant N entrées de commande, N entrées de courant et N sorties de courant, et comprenant N interrupteurs, commandés chacun par un signal C(0),...,C(N-1) reçu sur l'une des N entrées de commande, l'une des bornes de chaque interrupteur formant l'une des N entrées de courant de l'étage, l'autre borne formant l'une des N sorties de courant de l'étage, les N entrées de courant de l'étage étant reliées aux N sorties de courant de l'étage de transconductance, les N entrées de commande formant l'entrée numérique de l'amplificateur, destinée à recevoir le mot de commande C(O:N-1),

.   un étage 40 dit de conversion courant/tension présentant N entrées de courant et une sortie de tension, les N entrées de courant étant reliées aux N sorties de courant de l'étage de commutation, la sortie de tension formant la sortie analogique de l'amplificateur, et délivrant une tension Vout représentative des courants reçus sur ses N entrées de courant. Cet étage 40 de conversion courant/tension est ici un réseau R/2R.

Dans un tel amplificateur à gain commandé, le courant Itr s'écrit I0/2+K.Vin.I0/2 ou encore (1+K.Vin).I0/2. Du fait de la nature de l'étage de commutation et des propriétés du réseau R/2R, la tension de sortie Vout de l'amplificateur est égale à $Itr.R.CODE/2^N$, où CODE est la valeur décimale du mot de commande, et s'écrit donc $(1+K.Vin).R.I0.CODE/2^{N+1}$. Le gain dynamique Gd, défini comme le rapport des composantes variables de la tension de sortie et de la tension d'entrée, s'écrit alors $Gd=K.I0.R.CODE/2^{N+1}$, et est effectivement déterminé par la valeur CODE du mot de commande.

Les sorties de l'étage de transconductance sont ici de nature asymétrique. Dans le cas où ces sorties sont de nature symétrique, les interrupteurs de l'étage de commutation sont dédoublés, et l'étage de conversion courant/tension est par exemple constitué d'un double réseau R/2R, qui délivre alors une tension de sortie analogique de nature symétrique.

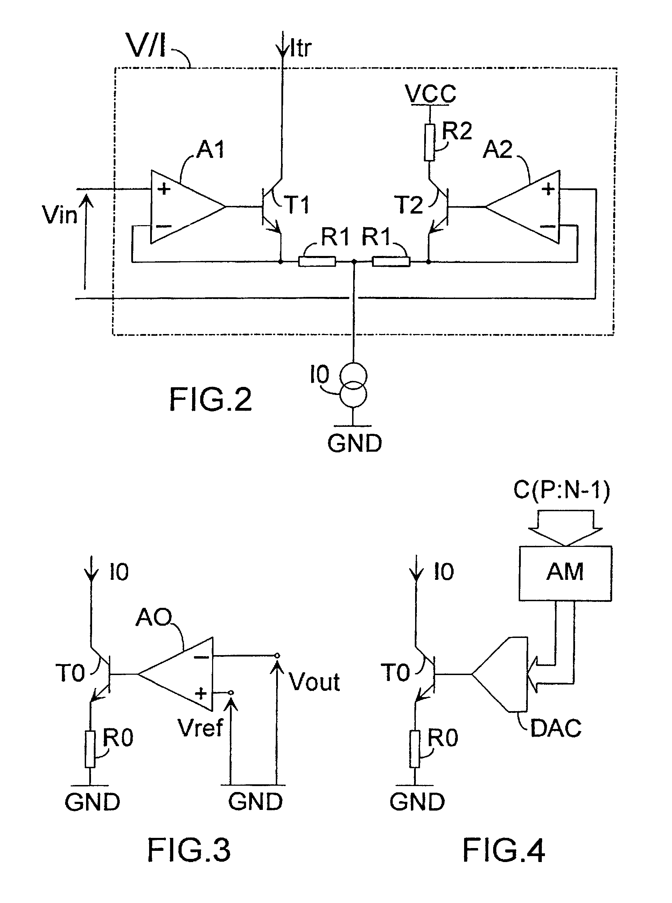

La figure 2 représente schématiquement un module de transconductance V/I présent dans un amplificateur à gain contrôlé AGC selon une variante de l'invention. Il comporte deux transistors T1, T2, montés en paire différentielle, des résistances de dégénérescence R1 reliant chacun des émetteurs des dits transistors T1, T2, à une source de courant I0 contenue dans l'étage de polarisation. Le collecteur de T1 constitue la sortie du module de transconductance V/I, tandis que le collecteur de T2 est relié par l'intermédiaire d'une résistance R2 à une borne positive d'alimentation VCC. La base de T1 est reliée à la sortie d'un amplificateur opérationnel A1 dont l'entrée inverseuse est reliée à l'émetteur de T1. La base de T2 est reliée à la sortie d'un amplificateur opérationnel A2 dont l'entrée inverseuse est reliée à l'émetteur de T2. La tension analogique d'entrée Vin est appliquée entre les deux entrées non-inverseuses des deux amplificateurs opérationnels A1 et A2. Ce montage est un exemple de module de transconductance V/I dont le courant de sortie Itr a une composante variable indépendante du courant I0 débité par la source de courant. En effet, la modulation des tensions base-émetteur des transistors due à une variation de I0 y est divisée par le gain élevé des amplificateurs opérationnels. Celui-ci étant supérieur à 100, cette modulation devient négligeable. Si itr est la composante variable du courant de sortie du module de transconductance et ic2 la composante variable du courant traversant le collecteur de T2, la différence itr-ic2 est égale à Vin/(2.R2). Comme itr=-ic2, on a itr=Vin/(4.R2). Le courant de sortie du module de transconductance V/I s'écrit donc : Itr=I0/2+Vin/(4.R2), ou encore Itr=I0/2+K'.Vin. La tension de sortie Vout d'un amplificateur à gain contrôlé tel que représenté sur la figure 1 incluant des modules de transconductance tels que celui représenté sur la figure 2 sera donc $Vout=Itr.R.CODE/2^N$, soit :

$$Vout=I0.R.CODE/2^{N+1}+K'.Vin.CODE/2^N$$

Un tel module de transconductance permet donc d'ajuster la composante continue de la tension analogique de sortie de l'amplificateur, sans que le gain dynamique de ce dernier soit modifié. Ceci est très utile pour le traitement des signaux video, dont les oscillations doivent pouvoir être amplifiées de manière variable sans que leur niveau continu, qui constitue un niveau de référence et sert au traitement ultérieur du signal amplifié, ne s'en trouve modifié.

La figure 3 représente schématiquement un dispositif de régulation de niveau continu de la tension analogique de sortie de l'amplificateur. Un tel dispositif comprend un comparateur AO présentant une sortie et deux entrées, dont l'une reçoit une tension de référence Vref, et l'autre reçoit la tension de sortie Vout de l'amplificateur. La figure 3 représente également une des sources de courant de l'étage de polarisation, constituée ici d'un transistor TO, dont l'émetteur est relié par l'intermédiaire d'une résistance RO à la borne négative d'alimentation GND. La base du transistor TO constitue l'entrée de commande de la valeur du courant IO débité par la source de courant. La sortie du comparateur AO est reliée à l'entrée de commande de chacune des sources de courant de l'étage de polarisation. Quand la valeur CODE du mot de commande provoque une trop grande augmentation de Vout, et donc une augmentation de son niveau continu, la tension de sortie du comparateur AO diminue, provoquant ainsi une diminution de la conduction de TO. IO diminue alors, ce qui compense l'augmentation de CODE dans la composante continue de la tension analogique d'entrée Vout explicitée dans l'équation $Vout=IO.R.CODE/2^{N+1}+K'.Vin.CODE/2^N$. Le gain dynamique reste inchangé.

La figure 4 représente schématiquement un autre dispositif de régulation de niveau continu de la tension analogique de sortie de l'amplificateur. Un tel dispositif comprend une mémoire AM dite associative, adressée par au moins une partie du mot de commande C(P:N-1) et délivrant en sortie une valeur numérique précalculée correspondant à la configuration de la dite partie du mot de commande C(P:N-1). Le dispositif de régulation comprend de plus un convertisseur numérique/analogique DAC muni d'une entrée numérique reliée à la sortie de la mémoire associative AM. La figure 4 représente également une des sources de courant de l'étage de polarisation, constituée ici d'un transistor TO, dont l'émetteur est relié par l'intermédiaire d'une résistance RO à la borne négative d'alimentation GND. La base du transistor TO constitue l'entrée de commande de la valeur du courant IO débité par la source de courant. La sortie du convertisseur numérique/analogique DAC est reliée à l'entrée de commande de chacune des sources de courant de l'étage de polarisation. La mémoire associative permet d'ajuster rapidement la valeur du courant I0. En effet, à chaque configuration différente de la partie du mot de commande C(P:N-1) adressant la mémoire associative AM correspond une valeur stockée dans ladite mémoire, valeur qui a été précalculée sur la base de la formule donnant la valeur de la composante continue de la tension de sortie analogique. Celle-ci donne réciproquement la valeur du courant de polarisation I0 en fonction de la valeur de CODE, la valeur du niveau continu étant fixée. Le mot numérique associé à cette valeur de CODE sera donc celui qui, une fois converti en analogique, commandera la base de T0 de sorte que celui-ci débite le courant I0 calculé précédemment. Plus le nombre N-P-1 de bits de la partie du mot de commande C(P:N-1) adressant la mémoire associative AM sera important, plus celle-ci contiendra de valeurs précalculées et plus la définition de celles-ci sera précise. Le réglage du niveau continu de la tension de sortie analogique en sera donc affiné.

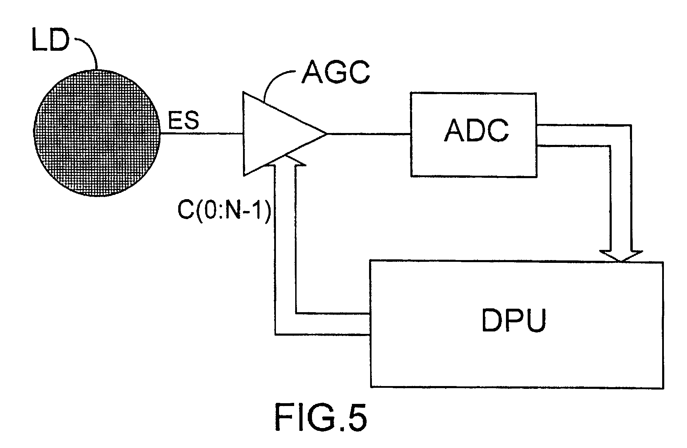

La figure 5 est un schéma fonctionnel décrivant partiellement une caméra comportant un amplificateur à gain contrôlé selon l'invention. Une telle caméra contient :

. un dispositif LD de détection de lumière et de conversion de la lumière en signaux électroniques analogiques ES,

. un amplificateur AGC tel que décrit plus haut, présentant une entrée de signal analogique recevant les dits signaux électroniques analogiques ES, une entrée numérique recevant un mot numérique C(O:N-1), dit mot de commande, servant à contrôler le gain, et une sortie de signal analogique,

. un convertisseur analogique/numérique ADC présentant une entrée analogique reliée à la sortie de l'amplificateur AGC, et une sortie numérique, et

. une unité de traitement numérique DPU dont une entrée est reliée à la sortie du convertisseur analogique/numérique ADC, unité émettant vers l'amplificateur AGC le mot de commande C(O:N-1).

**Revendications**

1. Amplificateur à gain contrôlé (AGC), présentant une entrée analogique destinée à recevoir une tension (Vin) dite tension analogique d'entrée, une entrée numérique destinée à recevoir un mot de N bits C(O:N-1), dit mot de commande, servant à contrôler le gain de l'amplificateur, et une sortie analogique destinée à délivrer une tension (Vout) dite tension analogique de sortie, **caractérisé en ce qu'**il comprend :

. un étage dit de transconductance (20) présentant une entrée de tension formant l'entrée analogique de l'amplificateur, et N sorties de courant, muni de moyens pour produire sur chacune de ses N sorties de courant un courant (Itr) présentant une composante variable représentative de la tension analogique d'entrée (Vin),

. un étage dit de commutation (30) présentant N entrées de commande, et comprenant N interrupteurs, commandés chacun par un signal reçu sur l'une des N entrées de commande, chaque interrupteur commandant l'activation ou la désactivation de l'une des sorties de courant de l'étage de transconductance (20), les N entrées de commande formant l'entrée numérique de l'amplificateur, destinée à recevoir le mot de commander C(O:N-1),

. un étage dit de conversion courant/tension (40) présentant N entrées de courant et une sortie de tension, les N entrées de courant étant reliées aux N sorties de courant de l'étage de transconductance (20), la sortie de tension formant la sortie analogique de l'amplificateur, et délivrant une tension (Vout) représentative des courants (Itr) reçus sur ses N entrées de courant.

2. Amplificateur à gain contrôlé (AGC), présentant une entrée analogique destinée à recevoir une tension (Vin) dite tension analogique d'entrée, une entrée numérique destinée à recevoir un mot de N bits C(O:N-1), dit mot de commande, servant à contrôler le gain de l'amplificateur, et une sortie analogique destinée à délivrer une tension (Vout) dite tension analogique de sortie, **caractérisé en ce qu'**il comprend :

   . un étage dit de polarisation (10) présentant N sorties et constitué de N sources de courant (IO), chacune ayant une borne reliée à une borne négative d'alimentation (GND), l'autre borne formant l'une des dites N sorties,

   . un étage dit de transconductance (20) présentant une entrée de tension formant l'entrée analogique de l'amplificateur, N entrées de courant reliées aux N sorties de l'étage de polarisation, et N sorties de courant, et constitué de N modules dits de transconductance (V/I), chacun d'eux présentant une entrée de tension reliée à l'entrée de tension de l'étage, une entrée de courant constituant une entrée de courant de l'étage, et une sortie de courant formant une des N sorties de courant de l'étage et délivrant un courant (Itr) présentant une composante variable représentative de la tension analogique d'entrée,

   . un étage dit de commutation (30) présentant N entrées de commande, N entrées de courant et N sorties de courant, et comprenant N interrupteurs, commandés chacun par un signal reçu sur l'une des N entrées de commande, l'une des bornes de chaque interrupteur formant l'une des N entrées de courant de l'étage, l'autre borne formant l'une des N sorties de courant de l'étage, les N entrées de courant de l'étage étant reliées aux N sorties de courant de l'étage de transconductance (20), les N entrées de commande formant l'entrée numérique de l'amplificateur, destinée à recevoir le mot de commande C(O:N-1),

   . un étage dit de conversion courant/tension (40) présentant N entrées de courant et une sortie de tension, les N entrées de courant étant reliées aux N sorties de courant de l'étage de commutation (30), la sortie de tension formant la sortie analogique de l'amplificateur, et délivrant une tension (Vout) représentative des courants (Itr) reçus sur ses N entrées de courant.

3. Amplificateur à gain contrôlé (AGC) selon l'une des revendications 1 ou 2, **caractérisé en ce que** l'étage de conversion courant/tension (40) comprend un réseau R/2R, dans lequel deux entrées de courant successives sont reliées l'une à l'autre par une résistance de valeur nominale égale à R, l'entrée de courant qui est reliée à la sortie de l'étage de transconductance (20) commandée par le bit de poids le plus fort C(N-1) du mot de commande C(O:N-1) étant reliée par une résistance de valeur nominale égale à R à la sortie analogique de l'amplificateur, l'entrée de courant qui est reliée à la sortie de l'étage de transconductance (20) commandée par le bit de poids le plus faible C(O) du mot de commande C(O:N-1) étant reliée à la borne négative d'alimentation (GND) par une résistance de valeur nominale égale à R, chacune des autres entrées de courant étant reliée à la borne négative d'alimentation (GND) par une résistance de valeur nominale égale à 2R.

4. Amplificateur à gain contrôlé (AGC) selon l'une des revendications 2 ou 3, **caractérisé en ce que** les sources de courant (I0) de l'étage de polarisation (10) sont toutes de construction identique et munies chacune d'une entrée de commande permettant de contrôler la valeur du courant qu'elle débite, en fonction de la valeur du mot de commande C(O:N-1).

5. Amplificateur à gain contrôlé (AGC) selon la revendication 4, **caractérisé en ce que** chaque module de transconductance (V/I) est muni de moyens pour produire à sa sortie de courant un courant (Itr) dont la composante variable est indépendante de la valeur du courant débité par la source de courant (IO) à laquelle ledit module est relié.

6. Amplificateur à gain contrôlé (AGC) selon la revendication 5, **caractérisé en ce qu'**il comprend un comparateur (A0) présentant une sortie et deux entrées, dont l'une reçoit une tension de référence, (Vref) et l'autre reçoit la tension de sortie (Vout) de l'amplificateur, la sortie du comparateur étant reliée à l'entrée de commande de chacune des sources de courant de l'étage de polarisation.

7. Amplificateur à gain contrôlé (AGC) selon la revendication 5, **caractérisé en ce qu'**il comprend une mémoire dite associative (AM), adressée par au moins une partie C(P:N-1) du mot de commande et délivrant en sortie une valeur numérique précalculée correspondant à la configuration de la dite partie du mot de commande, amplificateur comprenant de plus un convertisseur numérique/analogique (DAC) muni d'une entrée numérique reliée à la sortie de la mémoire associative et d'une sortie analogique reliée à l'entrée de commande de chacune des sources de courant de l'étage de polarisation.

8. Caméra contenant :

    . un dispositif (LD) de détection de lumière et de conversion de la lumière en signaux électroniques analogiques (ES),
    . un amplificateur (AGC) présentant une entrée de signal analogique destinée à recevoir les dits signaux électroniques analogiques (ES), une entrée numérique destinée à recevoir un mot numérique C(O:N-1), dit mot de commande, pour contrôler le gain de l'amplificateur (AGC), et une sortie de signal analogique,
    . un convertisseur analogique/numérique (ADC) présentant une entrée analogique reliée à la sortie de l'amplificateur (AGC), et une sortie numérique, et
    . une unité de traitement numérique (DPU) dont une entrée est reliée à la sortie du convertisseur analogique/numérique (ADC), unité destinée à émettre le mot de commande C(O:N-1) vers l'amplificateur (AGC),

    **caractérisée en ce que** ledit amplificateur (AGC) est conforme à l'une des revendications 1 à 7.

**Patentansprüche**

1. Verstärker mit gesteuerter Verstärkung (AGC), mit einem analogen Eingang für den Erhalt einer sogenannten analogen Eingangsspannung (Vin), einem digitalen Eingang für den Erhalt eines Wortes mit N Bits C(O:N-1), dem sogenannten Steuerbit, das zur Steuerung der Verstärkung des Verstärkers dient, und einem analogen Ausgang zur Abgabe einer sogenannten analogen Ausgangsspannung (Vout), **dadurch gekennzeichnet, dass** er enthält:

    . eine sogenannte Transkonduktanzstufe (20) mit einem Spannungseingang, der den analogen Eingang des Verstärkers bildet, und N Stromausgängen, versehen mit Verfahren zum Erzeugen an jedem seiner N Stromausgänge eines Stroms (Itr) mit einer variablen Komponente, die für die analoge Eingangsspannung (Vin) repräsentativ ist,
    . einer sogenannten Umschaltstufe (30) mit N Steuereingängen und N Unterbrechern, gesteuert jeweils durch ein Signal, das an einem der N Steuereingänge erhalten wird, wobei jeder Unterbrecher die Aktivierung oder die Deaktivierung eines der Stromausgänge der Transkonduktanzstufe (20) steuert und die N Steuereingänge den digitalen Eingang des Verstärkers bilden, der für den Erhalt des Steuerworts C(O:N-1) bestimmt ist,
    . eine sogenannte Strom-Spannung-Umwandlungsstufe (40) mit N Stromeingängen und einem Spannungsausgang, wobei die N Stromeingänge mit den N Stromausgängen der Transkonduktanzstufe (20) verbunden sind, der Spannungsausgang den analogen Ausgang des Verstärkers bildet und eine repräsentative Spannung (Vout) der an seinen N Stromeingängen erhaltenen Ströme (Itr) abgibt.

2. Verstärker mit gesteuerter Verstärkung (AGC), mit einem analogen Eingang für den Erhalt einer sogenannten analogen Eingangsspannung (Vin), einem digitalen Eingang für den Erhalt eines Wortes mit N Bits C(O:N-1), dem sogenannten Steuerbit, das zur Steuerung der Verstärkung des Verstärkers dient, und einem analogen Ausgang zur Abgabe einer sogenannten analogen Ausgangsspannung (Vout), **dadurch gekennzeichnet, dass** er enthält:

    . eine sogenannte Polarisationsspannung (10) mit N Ausgängen, gebildet aus N Stromquellen (I0), wobei jede eine Klemme mit einer negativen Versorgungsklemme (GND) verbunden hat und die andere Klemme einen der besagten N Ausgänge bildet,
    . eine sogenannte Transkonduktanzstufe (20) mit einem Spannungseingang, der den analogen Eingang des Verstärkers bildet, N Stromeingängen, die mit den N Ausgängen der Polarisationsstufe verbunden sind, und N Stromausgängen, und gebildet aus N sogenannten Transkonduktanzmodulen (V/I), von denen jedes einen Spannungseingang aufweist, mit dem Eingang der Spannungsstufe verbunden, einen Stromeingang, der einen Stromeingang der Stufe bildet, und einen Stromausgang, der einen der N Stromausgänge der Stufe bildet, und einen Strom (Itr) abgibt, der eine repräsentative variable Komponente der analogen Eingangsspannung bildet,
    . einer sogenannten Umschaltstufe (30) mit N Steuereingängen, N Stromeingängen und N Stromausgängen, und mit N Unterbrechern, gesteuert jeweils durch ein Signal, das an einem der N Steuereingänge erhalten wird, wobei eine der Klemmen jedes Unterbrechers einen der N Stromeingänge der Stufe bildet, die andere Klemme einen der N Stromausgänge der Stufe bildet, die N Stromeingänge mit den N Stromausgängen der Transkonduktanzstufe (20) verbunden sind und die N Steuereingänge den digitalen Eingang des Verstärkers bilden, der für den Erhalt des Steuerworts C(O:N-1) bestimmt ist,
    . eine sogenannte Strom-Spannung-Umwandlungsstufe (40) mit N Stromeingängen und einem Spannungsausgang, wobei die N Stromeingänge mit den N Stromausgängen der Umschaltstufe (30) verbunden sind, der Spannungsausgang den analogen Ausgang des Verstärkers bildet und eine repräsentative Spannung (Vout) der an seinen N Stromeingängen erhaltenen Ströme (Itr) abgibt.

3. Verstärker mit gesteuerter Verstärkung (AGC) nach einem der Ansprüche 1 oder 2, **dadurch gekennzeichnet, dass** die Strom-Spannung-Umwandlungsstufe (40) ein R/2R-Netz aufweist, in dem zwei aufeinanderfolgende Stromeingänge über einen Widerstand nominalen Werts gleich R miteinander verbunden sind, wobei der Stromeingang, der mit dem Ausgang der Transkonduktanzstufe (20) verbunden ist, gesteuert von dem Bit mit dem größten Stellenwert C(N-1) des Steuerworts C(O:N-1), über einen Widerstand nominalen Werts gleich R mit dem analogen Ausgang des Verstärkers verbunden ist, der Stromeingang, der mit dem Ausgang der Transkonduktanzstufe (20) verbunden ist, gesteuert von dem Bit geringsten Stellenwerts C(O) des Steuerwortes C(O:N-1), mit der negativen Versorgungsklemme (GND) über einen Widerstand nominalen Werts gleich R verbunden ist, und jeder der anderen Stromeingänge mit der negativen Versorgungsklemme (GND) über einen Widerstand nominalen Werts gleich 2R verbunden ist.

4. Verstärker mit gesteuerter Verstärkung (AGC) nach einem der Ansprüche 2 oder 3, **dadurch gekennzeichnet, dass** die Stromquellen (IO) der Polarisationsstufe (10) alle identischer Bauweise und jeweils mit einem Steuereingang versehen sind, der die Steuerung des Stromwerts ermöglicht, den dieser je nach dem Wert des Steuerwortes C(O:N-1) abgibt.

5. Verstärker mit gesteuerter Verstärkung (AGC) nach Anspruch 4, **dadurch gekennzeichnet, dass** jedes Transkonduktanzmodul (V/I) mit Verfahren zum Erzeugen an seinem Stromausgang eines Stromes (Itr) versehen ist, dessen variable Komponente unabhängig von dem Wert des von der Stromquelle abgegebenen Werts ist, mit der das besagte Modul verbunden ist.

6. Verstärker mit gesteuerter Verstärkung (AGC) nach Anspruch 5, **dadurch gekennzeichnet, dass** er einen Vergleicher (AO) mit einem Ausgang und zwei Eingängen aufweist, von denen einer eine Referenzspannung (Vref) erhält, und der andere die Ausgangsspannung (Vout) des Verstärkers erhält, wobei der Ausgang des Vergleichers mit dem Steuereingang jeder der Stromquellen der Polarisationsstufen verbunden ist.

7. Verstärker mit gesteuerter Verstärkung (AGC) nach Anspruch 5, **dadurch gekennzeichnet, dass** er einen sogenannten Assoziativspeicher (AM) enthält, der zumindest von einem Teil des Steuerwortes C (P:N-1) adressiert wird und am Ausgang einen vorausberechneten digitalen Wert abgibt, der der Konfiguration des besagten Teils des Steuerwortes entspricht, wobei der Verstärker außerdem ein Digital-Analog-Wandlungsgerät (DAC) enthält, versehen mit einem digitalen Eingang, verbunden mit dem Ausgang des Assoziativspeichers und mit einem analogen Ausgang, mit dem Steuereingang jeder der Stromquellen der Polarisationsstufe verbunden.

8. Kamera mit:

   . einer Vorrichtung (LD) zur Erkennung von Licht und zur Umwandlung des Lichtes in analoge elektronische Signale (ES),

   . einem Verstärker (AGC) mit einem analogen Signaleingang für den Erhalt der besagten analogen elektronischen Signale (ES), einem digitalen Eingang für den Erhalt eines digitalen Wortes C(O:N-1), dem sogenannten Steuerwort, um die Verstärkung des Verstärkers (AGC) zu steuern, und einem analogen Signalausgang,

   . einem Analog-Digital-Wandlungsgerät (ADC) mit einem analogen Eingang, mit dem Ausgang des Verstärkers (AGC) verbunden, und einem digitalen Ausgang, und

   . einer digitalen Verarbeitungseinheit (DPU), von der ein Eingang mit dem Ausgang des Analog-Digital-Wandlungsgeräts (ADC) verbunden ist, dazu bestimmte Einheit, um das Steuerwort C (O:N-1) zum Verstärker (AGC) zu übertragen,

   **dadurch gekennzeichnet, dass** der Verstärker (AGC) einer der Ansprüche 1 bis 7 entspricht.

**Claims**

1. A gain-controlled amplifier (AGC) having an analog input for receiving an analog input voltage (Vin), a digital input for receiving a word of N bits C(O:N-1), referred to as control word, for controlling the gain of the amplifier, and an analog output for supplying an analog output voltage (Vout), **characterized in that** the amplifier comprises:

   - a transconductance stage (20) having a voltage input which constitutes the analog input of the amplifier, and N current outputs, provided with means for producing, at each N current output, a current (Itr) having a variable component which is representative of the analog input voltage (Vin),

- a switching stage (30) having N control inputs and comprising N switches each controlled by a signal received at one of the N control inputs, each switch controlling the activation or deactivation of one of the current outputs of the transconductance stage (20), the N control inputs constituting the digital input of the amplifier for receiving the control word C(O:N-1),
- a current/voltage conversion stage (40) having N current inputs and one voltage output, the N current inputs being connected to N current outputs of the transconductance stage (20), the voltage output constituting the analog output of the amplifier and supplying a voltage (Vout) which is representative of the currents (Itr) received at its N current inputs.

2. A gain-controlled amplifier (AGC) having an analog input for receiving an analog input voltage (Vin), a digital input for receiving a word of N bits C(O:N-1), referred to as control word, for controlling the gain of the amplifier, and an analog output for supplying an analog output voltage (Vout), **characterized in that** the amplifier comprises:

- a biasing stage (10) having N outputs and constituted by N current sources (IO), each having a terminal connected to a negative power supply terminal (GND), the other terminal constituting one of said N outputs,
- a transconductance stage (20) having a voltage input which constitutes the analog input of the amplifier, N current inputs connected to N outputs of the biasing stage, voltage input connected to the voltage input of the stage, a current input constituting a current input of the stage, and a current output constituting one of the N current outputs of the stage and supplying a current (Itr) having a variable component which is representative of the analog input voltage,
- a switching stage (30) having N control inputs, N current inputs and N current outputs, and comprising N switches each controlled by a signal received at one of the N control inputs, one of the terminals of each switch constituting one of the N current inputs of the stage, the other terminal constituting one of the N current outputs of the stage, the N current inputs of the stage being connected to N current outputs of the transconductance stage (20), the N control inputs constituting the digital input of the amplifier for receiving the control word C(O:N-1),
- a current/voltage conversion stage (40) having N current inputs and one voltage output, the N current inputs being connected to N current outputs of the switching stage (30), the voltage output constituting the analog output of the amplifier and supplying a voltage (Vout) which is representative of the currents (Itr) received at its N current inputs.

3. A gain-controlled amplifier (AGC) as claimed in claim 1 or 2, **characterized in that** the current/voltage conversion stage (40) comprises an R/2R network in which two successive current inputs are interconnected via a resistor having a nominal value which is equal to R, the current input connected to the transconductance stage's (20) output which is controlled by the most significant bit C(N-1) of the control word C(O:N-1) being connected to the analog output of the amplifier via a resistor having a nominal value which is equal to R, the current input connected to the transconductance stage's (20) output which is controlled by the least significant bit C(O) of the control word C(O:N-1) being connected to the negative power supply terminal (GND) via a resistor having a nominal value which is equal to R, each of the other current inputs being connected to the negative power supply terminal via a resistor having a nominal value which is equal to 2R.

4. A gain-controlled amplifier (AGC) as claimed in claim 2 or 3, **characterized in that** all the current sources (IO) of the biasing stage (10) have an identical construction and are each provided with a control input for controlling the current value supplied thereby as a function of the value of the control word C(O:N-1).

5. A gain-controlled amplifier (AGC) as claimed in claim 4, **characterized in that** each transconductance module (V/I) is provided with means for producing at its current output a current (Itr) whose variable component is independent of the value of the current supplied by the current source (IO) to which said module is connected.

6. A gain-controlled amplifier (AGC) as claimed in claim 5, **characterized in that** the amplifier comprises a comparator (AO) having one output and two inputs, one of which receives a reference voltage (Vref) while the other receives the output voltage (Vout) of the amplifier, the output of the comparator being connected to the control input of each current source of the biasing stage.

7. A gain-controlled amplifier (AGC) as claimed in claim 5, **characterized in that** the amplifier comprises an associative memory (AM) addressed by at least one part C(P:N-1) of the control word and supplying a precomputed digital value at its output corresponding to the configuration of said part of the control word, the amplifier also comprising a D/A converter (DAC) having a digital input which is connected to the output of the associative memory and an analog output which is connected to the control input of each current source of the biasing stage.

8. A camera comprising:

   - a device (LD) for detecting light and converting the light into analog electronic signals (ES),
   - an amplifier (AGC) having an analog signal input intended to receive said analog electronic signals (ES), a digital input intended to receive a digital word C(O:N-1), referred to as control word, for controlling the gain of the amplifier (AGC), and an analog signal output,
   - an A/D converter (ADC) having an analog input connected to the output of the amplifier (AGC), and a digital output, and
   - a digital processing unit (DPU) having an input connected to the output of the A/D converter (ADC), which unit is intended to apply the control word C(O:N-1) to the amplifier (AGC),

   **characterized in that** said amplifier (AGC) is an amplifier as claimed in any one of claims 1 to 7.

AGC

FIG.1

FIG.2

FIG.3

FIG.4

FIG.5